# EUROPEAN PATENT SPECIFICATION

(11) **EP 1 050 959 B1**
(45) Date of publication and mention of the grant of the patent: **09.12.2009**
(21) Application number: 00401250.6
(22) Date of filing: 05.05.2000
(51) Int. Cl.: H03H 7/01

(54) **Laminated LC filter**
Laminiertes LC-Filter
Filtre LC stratifié

(30) Priority: 07.05.1999 JP 12781999
(43) Date of publication of application: 08.11.2000
(73) Proprietor: MURATA MANUFACTURING CO., LTD., Nagaokakyo-shi, Kyoto 617-8555 (JP)
(72) Inventor: Kato, Noboru, c/o Murata Manufacturing Co., Ltd., Nagaokakyo-shi, Kyoto-fu 617-8555 (JP)
(74) Representative: Thévenet, Jean-Bruno

(56) References cited:
- EP-A- 0 844 625
- US-A- 5 404 118
- PATENT ABSTRACTS OF JAPAN vol. 1997, no. 12, 25 December 1997 (1997-12-25) & JP 09 214274 A (MURATA MFG CO LTD), 15 August 1997 (1997-08-15)
- PATENT ABSTRACTS OF JAPAN vol. 017, no. 347 (E-1391), 30 June 1993 (1993-06-30) & JP 05 048365 A (MURATA MFG CO LTD), 26 February 1993 (1993-02-26)

## Description

### BACKGROUND OF THE INVENTION

### 1. Field of the Invention

The present invention relates to a LC filter, and more particularly to a laminated LC filter that is used at high frequencies.

### 2. Description of the Related Art

Below, references to specific directions (e.g. «front», «back», «left» and «right») refer to the devices when oriented as shown in the respective figures.

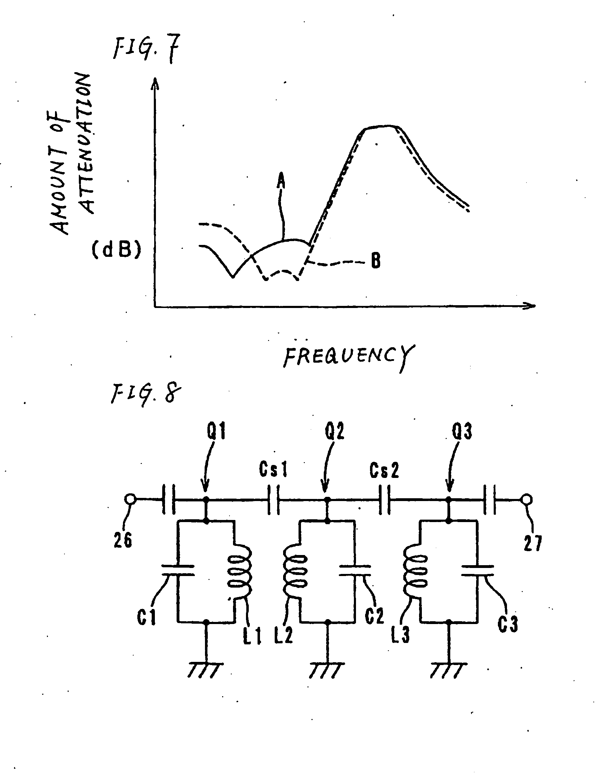

As the band pass filter of three or more stages that passes a signal of a specific frequency, for example, a circuit structure thereof is as shown in Fig. 8. The band pass filter is a three-stage band pass filter that is constituted of the LC resonators Q1 to Q3 of the first to third stages. These LC resonators Q1 to Q3 are such that the ones adjacent to each other are electrically coupled by the coupling capacitors Cs1, Cs2.

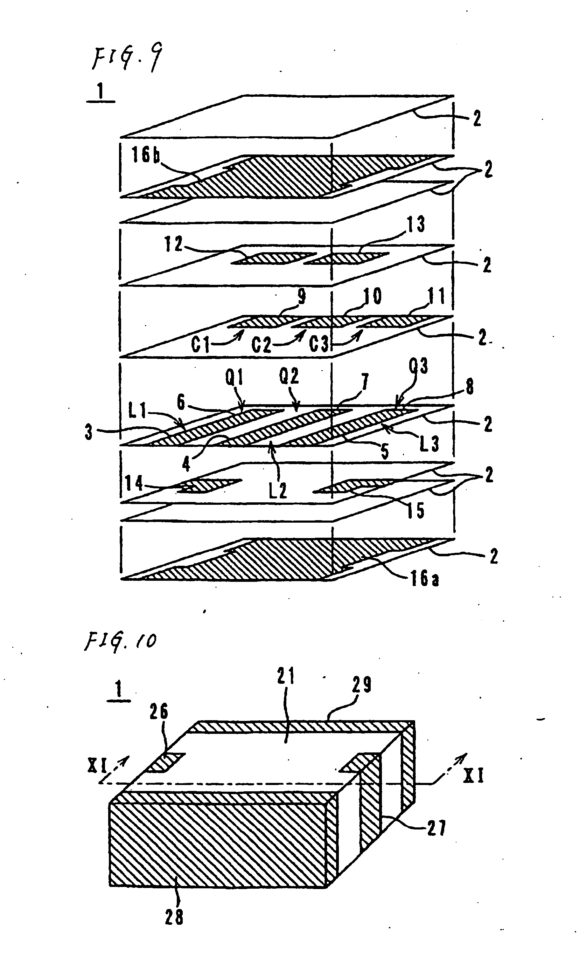

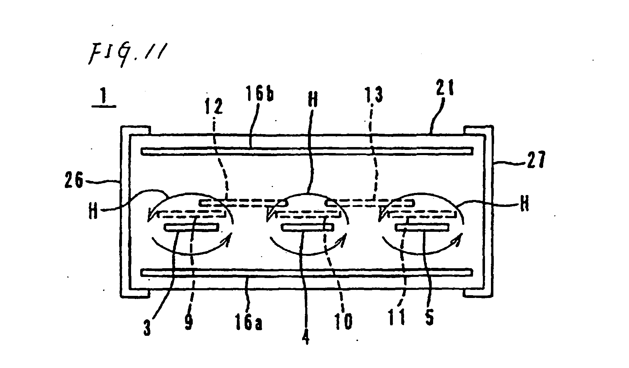

Conventionally, as the laminated band pass filter with the circuit structure described above, for example, there are ones with structures such as shown in Figs. 9 to 11. This LC filter 1 is one in which LC resonators Q1 to Q3 of the first to third stages are formed, within a laminate body 21 constituted by piling up ceramic sheets 2 having square shapes, and the equivalent circuit shown in Fig. 8 is constituted by these LC resonators Q1 to Q3.

The inductors L1 to L3 of the LC resonators Q1 to Q3 are formed respectively by the inductor patterns 3, 4, 5. The pattern widths of the inductor patterns 3, 4, 5 are set equal. The capacitances C1 to C3 of the LC resonators Q1 to Q3 are formed respectively by capacitor patterns 9, 10, 11, and leading edges 6, 7, 8 of the inductor patterns 3, 4, 5 that are opposite to these capacitor patterns 9, 10, 11. The above described LC resonators Q1 to Q3 are electrically connected by the coupling capacitors Cs1, Cs2 that are constituted of the capacitor patterns 9 to 11 and coupling capacitor patterns 12, 13 that are opposite to these capacitor patterns 9 to 11. These LC resonators Q1 and Q3 are capacitively-coupled to a capacitor pattern 14 for input and a capacitor pattern 15 for output, respectively. Then, shielding patterns 16a, 16b are arranged by sandwiching these patterns 3 to 5, 9 to 15.

In the laminated body 21, an input terminal electrode 26, an output terminal electrode 27 and shielding terminal electrodes 28, 29 such as shown in Fig. 10 are formed. The capacitor pattern 14 for input is connected to the input terminal electrode 26, the capacitor pattern 15 for output is connected to the output terminal electrode 27. The lead parts of the inductor patterns 3, 4, 5 and one end parts of the shielding patterns 16a, 16b are connected to the shielding terminal electrode 28. The lead parts of the capacitor patterns 9 to 11 and the other end parts of the shielding patterns 16a, 16b are connected to the shielding terminal electrode 29.

Incidentally, in general, the inductor pattern 4 that constitutes the LC resonator Q2 at the second stage located at the center is such that the magnetic field concentration at the pattern edge is large, compared to the inductor patterns 3, 5 that constitute the LC resonators Q1, Q3 of the first and third stages, located at both ends. Accordingly, a current density flowing through the inductor pattern 4 becomes larger than that in the inductor patterns 3, 5, and non-uniform. As a result, there is a problem that the Q characteristic of the LC filter 1 is poor.

Furthermore, document JP 0 921 4 274 discloses a laminated Lc composite filter comprising inductor and capacitor patterns laminated on a 2 stage stack structure.

### SUMMARY OF THE INVENTION

Accordingly, it is an object of the present invention to provide a laminated LC filter with an excellent Q characteristic.

The object of the present invention can be achieved by a laminated LC filter, which includes a laminated body constituted by stacking a plurality of insulation layers, a plurality of inductor patterns, and a plurality of capacitor patterns, said inductor patterns being strip-shaped and arranged side-by-side on an insulation layer such that there is at least one inner inductor pattern arranged between outer inductor patterns, and at least three LC resonators formed by the plurality of inductors that are formed by the inductor patterns, and the plurality of capacitors formed such that the capacitor patterns are opposite to the inductor patterns, at an inside of the laminated body, wherein a filter of three or more stages is constituted by connecting at least three of the LC resonators, the width of the inner inductor pattern being wider than the widths of the outer inductor patterns.

Preferably, each of the inductors of the respective LC resonators comprises two or more of the inductor patterns in identical shapes laminated via the insulation layers.

Making the pattern widths of the inductor patterns of the LC resonators located at other than both ends to be wider, the magnetic field at the edges of the inductor patterns is relaxed.

### BRIEF DESCRIPTION OF THE DRAWINGS

Further objects and advantages of the invention can be more fully understood from the following detailed description of preferred embodiments thereof, given by way of example, taken in conjunction with the accompanying drawings in which:
Fig. 1 is an exploded perspective view showing a structure of the first embodiment of the laminated LC filter according to the present invention;
Fig. 2 is a perspective view of the appearance of the laminated LC filter shown in Fig. 1;
Fig. 3 is a schematic diagram as seen from III - III in Fig. 2;
Fig. 4 is an exploded perspective view showing a structure of the second embodiment of the laminated LC filter according to the present invention;
Fig. 5 is a perspective view of the appearance of the laminated LC filter shown in Fig. 4;
Fig. 6 is a schematic diagram as seen from VI- VI in Fig. 5;
Fig. 7 is a graph showing an attenuation characteristic of the laminated LC filter shown in Fig. 5;
Fig. 8 is an electrical equivalent circuit diagram of a three-stage laminated LC filter;
Fig. 9 is an exploded perspective view of a conventional laminated LC filter;
Fig. 10 is a perspective view of the appearance of the conventional laminated LC filter shown in Fig. 9; and
Fig. 11 is a schematic diagram showing as seen from XI - XI in Fig. 10.

### DESCRIPTION OF THE PREFERRED EMBODIMENTS

In the following, the preferred embodiments of the laminated LC filter according to the present invention will be described with reference to the accompanying drawings. Each embodiment describes a band pass filter as an example thereof, but it may be a band stop filter or the like. First Embodiment

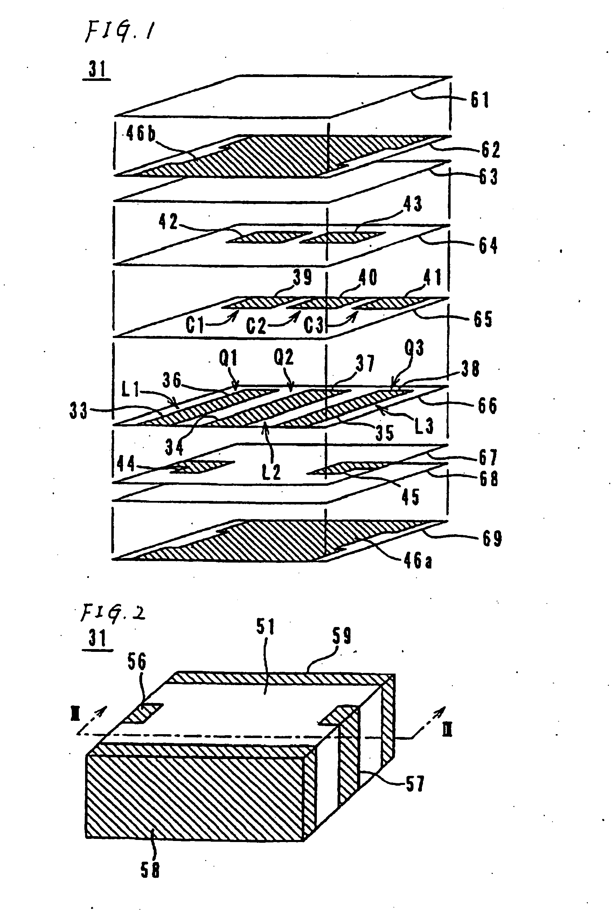

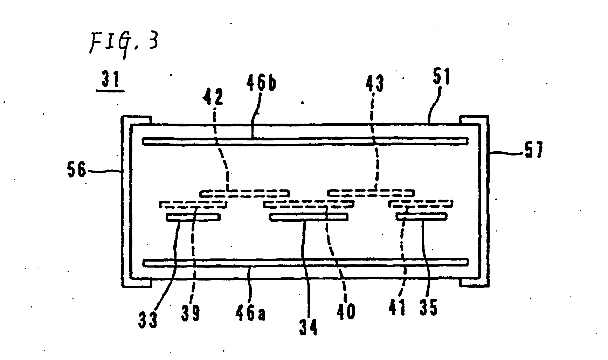

One embodiment of the band pass filter according to the present invention is shown in Figs. 1 to 3. The band pass filter 31 is one in which the present invention is applied to an LC filter constituted of the LC resonators Q1 to Q3 of the first to third stages as described in Fig. 8. In the LC filter 31 of the present first embodiment, the LC resonators Q1 to Q3 of the first to third stages are arranged, within the laminated body 51 constituted by laminating the ceramic sheets 61 to 69 having square shapes made of a ceramic dielectric material such as barium titanate or the like, and by firing integrally.

The inductor L1 of the LC resonator Q1 of the first stage (the initial stage) is, as shown in Fig. 1, formed by the inductance of a strip-shaped inductor pattern 33. Further, the capacitor C1 of the LC resonator Q1 is constituted of a capacitor pattern 39, and the leading edge 36 of the inductor pattern 33 that is opposite to the capacitor pattern 39 via the ceramic sheet 65.

The inductor L2 of the LC resonator Q2 of the second stage is formed by the inductance of a strip-shaped inductor pattern 34. Further, the capacitor C2 of the LC resonator Q2 is constituted of a capacitor pattern 40, and the leading edge 37 of the inductor pattern 34 that is opposite to the capacitor pattern 40.

The inductor L3 of the LC resonator Q3 of the third stage is formed by the inductance of a strip-shaped inductor pattern 35. Further, the capacitor C3 of the LC resonator Q3 is constituted of a capacitor pattern 41, and the leading edge 38 of the inductor pattern 35 that is opposite to the capacitor pattern 41.

The LC resonators Q1 to Q3 of the first to third stages as described above are such that the LC resonators Q1 and Q2 as well as the LC resonators Q2 and Q3, which are adjacent to each other, are electrically coupled by respective coupling capacitors Cs1, Cs2. Further, the LC resonators Q1 and Q3 are capacitively-coupled to a capacitor pattern 44 for input and to a capacitor pattern 45 for output, respectively.

The inductor patterns 33, 34 and 35 that are formed at the left-side, centrally, and at the right-side of the sheet 66, respectively, are such that one ends thereof are exposed at an edge at the front side of the sheet 66. The capacitor patterns 39, 40 and 41 that are formed at the left-side, centrally, and at the right-side of the sheet 65, respectively, are such that one ends thereof are exposed at an edge at the rear side of the sheet 65. Then, the inductor pattern 34 located at the center is such that the pattern width thereof is set approximately 10 % or more wider, than those of the inductor patterns 33, 35 located at both ends.

The coupling capacitor patterns 42, 43 are arranged at the rearside of the sheet 64, and are opposite to the capacitor patterns 39, 40 41 through the sheet 64, and form the coupling capacitors Cs1, Cs2, respectively. Further, the inductor patterns 33, 35 are capacitively-coupled to the capacitor pattern 44 for input and to the capacitor pattern 45 for output, respectively, by sandwiching the sheet 66. Then, shielding patterns 46a, 46b are arranged by sandwiching these patterns 33 to 35, 39 to 45.

In the laminated body 51, an input terminal electrode 56, an output terminal electrode 57 and shielding terminal electrodes 58, 59 such as shown in Fig. 2 are formed. The capacitor pattern 44 for input is connected to the input terminal electrode 56, the capacitor pattern 45 for output is connected to the output terminal electrode 57. The lead parts of the inductor patterns 33, 34, 35 and the one end parts of the shielding patterns 46a, 46b are connected to the shielding terminal electrode 58. The lead parts of the capacitor patterns 39 to 41 and the other end parts of the shielding patterns 46a, 46b are connected to the shielding terminal electrode 59.

The LC filter that is constituted of the structure described above is such that the inductor pattern 34 that constitutes the LC resonator Q2 of the second stage located at the center has a pattern width which is approximately 10 % or more wider, relative to the inductor patterns 33, 35 that constitute the LC resonators Q1, Q3 of the first and third stages, located at both ends. Accordingly, it is possible to relax the magnetic field at the edge of the inductor pattern 34. As a result, it is possible to obtain an LC filter 31 with an excellent Q characteristic.

### Second Embodiment

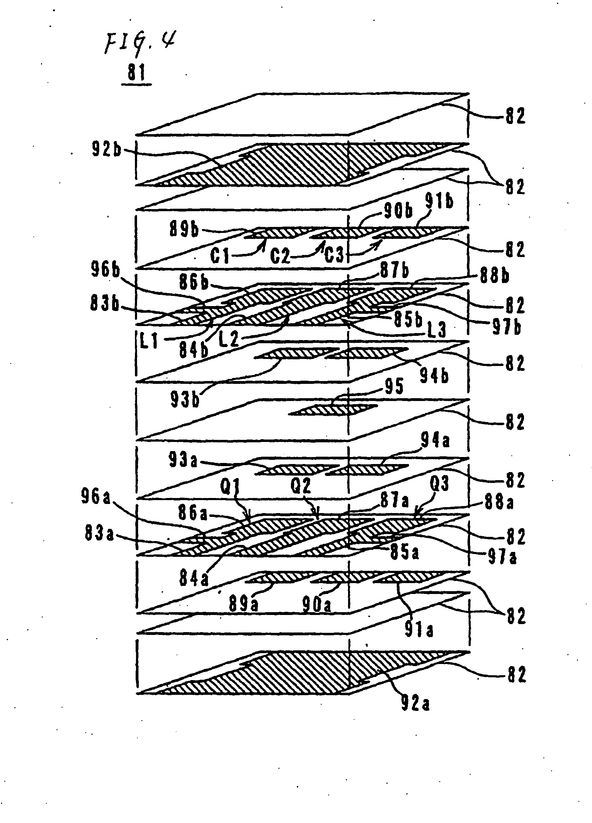

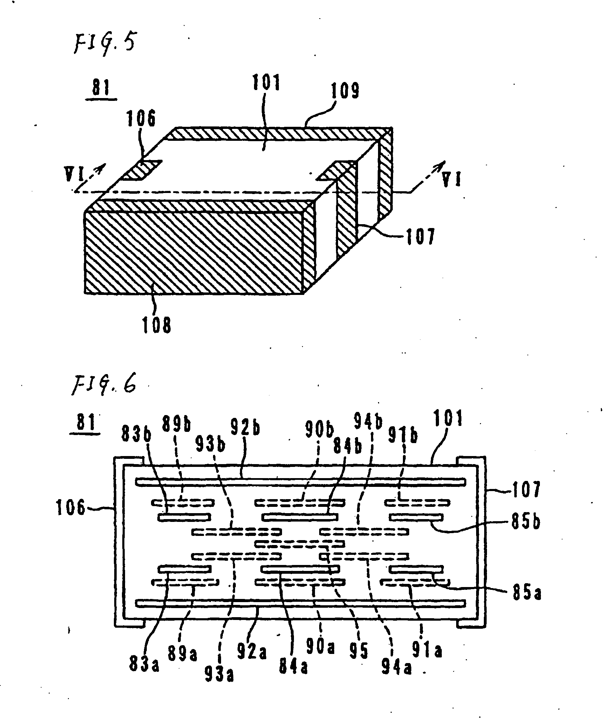

In Fig. 4, a structure of the LC filter 81 according to the second embodiment of the invention is shown, and in Fig. 5, a perspective view of the appearance of this LC filter 81 is shown. The LC filter 81 is a three-stage LC band pass filter, and the LC resonator Q1 of the first stage (the initial stage), the LC resonator Q2 of the second stage and the LC resonator Q3 of the third stage (the end stage) are cascade-connected (daisy-chained) through the coupling capacitors Cs1, Cs2.

As shown in Fig. 4, the LC filter 81 is constituted of two ceramic sheets 82 on the surface of which the inductor patterns 83a, 83b, 84a, 84b, 85a, 85b are provided respectively, two ceramic sheets 82 on the surface of which the capacitor patterns 89a, 89b, 90a, 90b, 91a, 91b are provided respectively, two ceramic sheets 82 on the surface of which the shielding patterns 92a, 92b are provided respectively, two ceramic sheets 82 on the surface of which the coupling capacitor patterns 93a, 93b, 94a, 94b are provided respectively, and a ceramic sheet 82 on the surface of which a pattern 95 for adjusting a pole or the like is provided.

The inductor patterns 83a, 83b have the same shape, and are laminated through the sheets 82, and constitute an inductor L1 of duplex structure. The inductor patterns 83a, 83b that are formed at the left-side locations of the sheet 82 are such that one ends thereof are exposed at an edge at the front side of the sheet 82. The other ends 86a, 86b of the inductor patterns 83a, 83b are enlarged, and these enlarged parts 86a, 86b also function as the capacitor patterns. The input lead patterns 96a, 96b that extend respectively from the central parts of the inductor patterns 83a, 83b are exposed on the left side of the sheet 82.

The inductor patterns 84a, 84b have the same shape, and are laminated through the sheets 82, and constitute an inductor L2 of duplex structure. The pattern widths of the inductor patterns 84a, 84b are set to be approximately 10 % or more wider relative to the pattern widths of the inductor patterns 83a, 83b, 85a, 85b. The inductor patterns 84a, 84b that are formed at the central locations of the sheet 82 are such that one ends thereof are exposed at an edge at the front side of the sheet 82. The other ends 87a, 87b of the inductor patterns 84a, 84b are enlarged, and these enlarged parts 87a, 87b also function as the capacitor patterns.

The inductor patterns 85a, 85b have the same shape, and are laminated through the sheets 82, and constitute an inductor L3 of duplex structure. The inductor patterns 85a, 85b that are formed at the right-side locations of the sheet 82 are such that one ends thereof are exposed at an edge at the front side of the sheet 82. The other ends 88a, 88b of the inductor patterns 85a, 85b are enlarged, and these enlarged parts 88a, 88b also function as the capacitor patterns. The output lead patterns 97a, 97b that extend respectively from the central parts of the inductor patterns 85a, 85b are exposed on the right side of the sheet 82.

The capacitor patterns 89a, 89b are formed at the left-side locations of the sheet 82, and one ends thereof are exposed at an edge at the rear side of the sheet 82. In the piling-up direction of the sheets 82, an inductor L1 of a duplex structure that is constituted of the inductor patterns 83a, 83b is arranged between the capacitor patterns 89a, 89b. These capacitor patterns 89a, 89b are opposite to the enlarged parts 86a, 86b of the inductor patterns 83a, 83b, and form the capacitor C1. Then, a LC parallel resonance circuit is formed by the capacitor C1 and the inductor L1 of the duplex structure, and constitutes the LC resonator Q1 of the first stage.

The capacitor patterns 90a, 90b are formed in the central locations of the sheet 82, and one ends thereof are exposed at an edge at the rear side of the sheet 82. An inductor L2 of duplex structure that is constituted of the inductor patterns 84a, 84b is arranged between the capacitor patterns 90a and 90b. These capacitor patterns 90a, 90b are opposite to the enlarged parts 87a, 87b of the inductor patterns 84a, 84b, and form the capacitor C2. Then, a LC parallel resonance circuit is formed by the capacitor C2 and the inductor L2 of duplex structure, and constitutes the LC resonator Q2 of the second stage.

The capacitor patterns 91a, 91b are formed at the right-side locations of the sheet 82, and one ends thereof are exposed at an edge at the rear side of the sheet 82. An inductor L3 of a duplex structure that is constituted of the inductor patterns 85a, 85b is arranged between the capacitor patterns 91a and 91b. These capacitor patterns 91a, 91b are opposite to the enlarged parts 88a, 88b of the inductor patterns 85a, 85b, and form the capacitor C3. Then, a LC parallel resonance circuit is formed by the capacitor C3 and the inductor L3 of duplex structure, and constitutes the LC resonator Q3 of the third stage.

The coupling capacitor patterns 93a, 93b, 94a, 94b are provided at a rear side of the sheet 82, and in the piling-up direction of the sheets 82, they are located between the inductor patterns 83a, 84a, 85a and the inductor patterns 83b, 84b, 85b. These coupling capacitor patterns 93a, 93b are opposite to the inductor patterns 83a, 83b, 84a, 84b by sandwiching the sheet 82, and form the coupling capacitor Cs1. The coupling capacitor patterns 94a, 94b are opposite to the inductor patterns 84a, 84b, 85a, 85b by sandwiching the sheet 82, and form the coupling capacitor Cs2.

A pattern 95 for adjusting a pole is arranged between the coupling capacitor patterns 93a, 94a and 93b, 94b. This pattern 95 for adjusting the pole is opposite to the coupling capacitor patterns 93a, 94a, 93b, 94b by sandwiching the sheet 82, and forms a capacitance. The shielding patterns 92a, 92b with wide areas are such that one ends thereof are exposed at the front side, and the other ends thereof are exposed at the rear side of the ceramic sheet, respectively.

Each sheet 82 configured as described above is piled up in sequence as shown in Fig. 4, and is made to be the laminated body 101 as shown in Fig. 5 by firing integrally. An input terminal electrode 106 and an output terminal electrode 107 are formed at the left and right ends of the laminated body 101, respectively, and shielding electrodes 108, 109 are formed at the front and rear sides, respectively. The input lead patterns 96a, 96b are connected to the input terminal electrode 106, and the output lead patterns 97a, 97b are connected to the output terminal electrode 107. One ends of the inductor patterns 83a to 85b and one ends of the shielding patterns 92a, 92b are connected to the shielding terminal electrode 108. One ends of the capacitor patterns 89a to 91b and the other ends of the shielding patterns 92a, 92b are connected to the shielding terminal electrode 109.

In this LC filter 81, as shown in Fig. 6, the inductor patterns 84a, 84b that constitute the LC resonator Q2 of the second stage located at the center of the filter 81 are such that the pattern widths thereof are made 10 % or more wider than those of the inductor patterns 83a, 83b, 85a, 85b that constitute the LC resonators Q1, Q3 of the first and third stages, which are located at both ends. Accordingly, the magnetic field H at the edges of the inductor patterns 84a, 84b can be relaxed. As a result, it is possible to obtain the LC filter 81 with an excellent Q characteristic.

Further, because the inductors L1 to L3 have duplex structures, the distribution of the magnetic field H generated in the respective surroundings of the inductors L1 to L3 can be optimized by adjusting a space between the inductor patterns 83a and 83b, a space between the inductor patterns 84a and 84b, and a space between the inductor patterns 85a and 85b, thereby enabling to further relax the magnetic field H so as not to be concentrated at the edges of the inductor patterns 83a to 85b. As a result, the LC filter 81 with an excellent Q characteristic can be obtained.

Moreover, no magnetic field is generated between the inductor patterns 83a and 83b, between the inductor patterns 84a and 84b, or between the inductor pattern 85a and 85b that constitute each of the inductors L1 to L3, and thus the coupling capacitor patterns 93a to 94b that are arranged between the inductor patterns 83a, 84a, 85a and 83b, 84b 85b and the pattern 95 for adjusting the pole rarely block the magnetic field H of the inductors L1 to L3. As a result, a uniform magnetic field H is formed, thereby obtaining a large inductance.

Further, by changing the opposed areas of the pattern 95 for adjusting the pole and the coupling capacitor patterns 93a to 94b, the pole distance of the LC filter 81 can be adjusted. For example, when the opposed areas are large, the capacitance that is generated between the pattern 95 for adjusting the pole and the coupling capacitor patterns 93a to 94b becomes large, and as shown with the solid line A in Fig. 7, this produces an attenuation characteristic in which the pole distance is large. On the contrary, when the opposed areas are small, as shown with the dotted line B in Fig. 7, this produces an attenuation characteristic in which the pole distance is small.

Incidentally, the laminated LC filter according to the present invention is not limited to the embodiments described above, but it may be modified in various forms within the gist thereof. For example, the LC resonators included in the laminated LC filter may be four or more. When there are four or more LC resonators, the same effect can be obtained by making at least one width of the inductor patterns to be wider, without making widths of all inductor patterns located at other than both ends to be wider.

Further, the embodiments described above are the ones that after having piled-up the ceramic sheets on which the patterns are formed, respectively, they are fired integrally, but the invention is not limited thereto. The ceramic sheets may be the ones that have been fired in advance. Moreover, the LC filter may be produced by a manufacturing method as described below. After having formed a ceramic layer with a ceramic material in a paste form by a method of printing or the like, an arbitrary pattern is formed by applying a conductive pattern material in a paste form on a surface of the ceramic layer. Then, the ceramic material in paste form is applied on the conductive pattern so as to make the ceramic layer in which the conductive pattern is provided. Similarly, by applying ceramic material in sequence, a LC filter with a laminated structure will be obtained.

As apparent from the above description, according to the present invention, since the pattern widths of the inductor patterns that constitute the LC resonators located at other than both ends are made wider than the pattern widths of the inductor patterns that constitute the LC resonators located at both ends, it is possible to relax the magnetic field at the edges of the inductor patters of the LC resonators located at other than both ends. As a result, it is possible to obtain a laminated LC filter with an excellent Q characteristic.

The invention may be embodied in other specific forms without departing from the essential characteristics thereof. The present embodiments are therefore to be considered in all respects as illustrative and not restrictive, the scope of the invention being indicated by the appended claims rather than by foregoing description.

## Claims

1. A laminated LC filter, comprising:
a laminated body (31) constituted by stacking a plurality of insulation layers (61-69), a plurality of inductor patterns (33-35), and a plurality of capacitor patterns (39-41), said inductor patterns being strip-shaped and arranged side-by-side on an insulation layer such that there is at least one inner inductor pattern arranged between outer inductor patterns; and
at least three LC resonators (Q1-Q3) formed by the plurality of inductors (L1-L3) that are formed by said inductor patterns (33-35), and the plurality of capacitors (C1-C3) formed such that said capacitor patterns (39-41) are opposite to said inductor patterns (33-35), at an inside of said laminated body,
wherein a filter of three or more stages is constituted by connecting at least three of said LC resonators, the width of the inner inductor pattern (34) being wider than the widths of the outer inductor patterns (33,35).

2. A laminated LC filter (81) according to claim 1, wherein each of said inductors (L1/L2/L3) of the respective LC resonators comprises two or more (83a,b/84a,b/85a,b) of said inductor patterns in identical shapes laminated via said insulation layers (82).

## Patentansprüche

1. Ein laminierte LC-Filter mit:
einem laminierten Körper (31), der durch ein Stapeln einer Mehrzahl von Isolierungsschichten (61 - 69), eine Mehrzahl von Induktorstrukturen (33 - 35) und eine Mehrzahl von Kondensatorstrukturen (39 - 41) gebilde ist, wobei die Induktorstrukturen streifenförmig und Seite an Seite auf einer Isolierungsschicht angeordnet sind, derart, dass zumindest eine Inneninduktorstruktur zwischen Außeninduktorstrukturen angeordnet ist; und
zumindest drei LC-Resonatoren (Q1 - Q3), die gebildet sind durch die Mehrzahl vorn Induktoren (L1 - L3), die durch die Induktorstrukturen (33 - 35) gebildet sind, und die Mehrzahl von Kondensatoren (C1 - C3), die derart gebildet sind, dass die Kondensatorstrukturen (39 - 41) gegenüber den Induktorstrukturen (33 - 35) sind, an eimer Innenseite des laminierten Körpers,
wobei ein Filter mit drei oder mehr Stufen durch ein Verbinden von zumindest drei der LC-Resonatoren gebildet ist, wobei die Breite der Inneninduktorstruktur (34) breiter als die Breiten der Außeninduktorstrukturen (33, 35) sind.

2. Ein laminiertes LC-Filter (81) gemäß Anspruch 1, bei dem jeder der Induktoren (L1/L2/L3) des jeweiligen LC-Resonators zwei oder mehr (83a,b/84a,b/85a,b) der Induktorstrukturen in identischen Formen aufweiset, die über die Isolierungsschichten (82) laminiert sind.

## Revendications

1. Filtre LC stratifié comprenant :
un corps stratifié (31) constitué en empilant une pluralité de couches d'isolation (61 à 69), une pluralité de configurations d'inducteur (33 à 35) et une pluralité de configurations de condensateur (39 à 41), lesdites configurations d'inducteur ayant une forme de bande et étant agencées côte à côte sur une couche d'isolation de telle sorte qu'il y ait au moins une configuration d'inducteur intérieur agencée entre des configurations d'inducteur extérieur ; et
au moins trois résonateurs LC (Q1 à Q3) formés par la pluralité d'inducteurs (L1 à L3) qui sont Formés par lesdites configurations d'inducteur (33 à 35), et la pluralité de condensateurs (C1 à C3) formés de telle sorte que lesdites configurations de condensateur (39 à 41) soient opposées auxdites configurations d'inducteur (33 à 35), à l'intérieur dudit corps stratifié,
dans lequel un filtre de trois étages ou plus est constitué en reliant au moins trois desdits résonateurs LC, la largeur de la configuration d'inducteur intérieur (34) étant supérieure aux largeurs des configurations d'inducteur extérieur (33, 35).

2. Filtre LC stratifié (81) selon la revendication 1, dans lequel chacun desdits inducteurs (L1 / L2 / L3) des résonateurs LC respectifs comprend au moins deux (83a, b / 84a, b / 85a, b) desdites configurations d'inducteur de formels identiques stratifiées via lesdites couches d'isolation (82).
